Europäisches Patentamt

European Patent Office

Office européen des brevets

(11) Publication number: **0 322 997**
**A2**

## (12) EUROPEAN PATENT APPLICATION

(21) Application number: 88306408.1

(22) Date of filing: 13.07.88

(51) Int. Cl.⁴: **H05K 3/12 , H05K 3/46 ,
H05K 3/28**

(30) Priority: 31.12.87 KR 8715679

(43) Date of publication of application:
05.07.89 Bulletin 89/27

(84) Designated Contracting States:
AT BE CH DE ES FR GB GR IT LI LU NL SE

(71) Applicant: JUNGPOONG PRODUCTS CO., LTD.
262-10, Banghwa-dong Kangseo-ku
Seoul(KR)

Applicant: Moon, Duk Man
13-dong 1102-ho Walkerhill APT
Kwangjang-dong
Seongdong-ku Seoul(KR)

(72) Inventor: Moon, Duk Man
13-dong 1102-ho Walkerhill Apt.
Kwangjang-dong
Seongdong-ku seoul(KR)
Inventor: Lee, Soo Joung
35-58, Byun-dong Seo-ku Daejeon-si
Chungcheongnam-do(KR)

(74) Representative: Jackson, Peter Arthur et al
GILL JENNINGS & EVERY 53-64 Chancery
Lane
London WC2A 1HN(GB)

(54) **Process for making printed circuit boards.**

(57) A printed circuit board is formed by printing on
an insulating substrate (10) a circuit pattern of a
conductive material (11). A metal layer (12,12') is
plated onto the conductive resin and an insulating
coating (13) is applied over all but contact portions
(14), some of which are perforated to accommodate
components.

Fig.1(A)

Fig.1(B)

Fig.1(E)

Fig.1(F)

Fig.1(C)

Fig.1(D)

## PROCESS FOR MAKING PRINTED CIRCUIT BOARDS

Printed circuit boards (PCB) are commonly used in electronic household goods and in industrial machinery and tools. Previously copper substrates have been used to prepare the printed circuit boards. Such substrate was manufactured by attaching a thin copper film, having a certain thickness to one or both sides of an electrically insulating base with a melting point above 250° C. Subsequently, a circuit pattern was printed on the substrate and then the portion outside the circuit pattern was removed by etching with a corrosive to form the desired copper circuit.

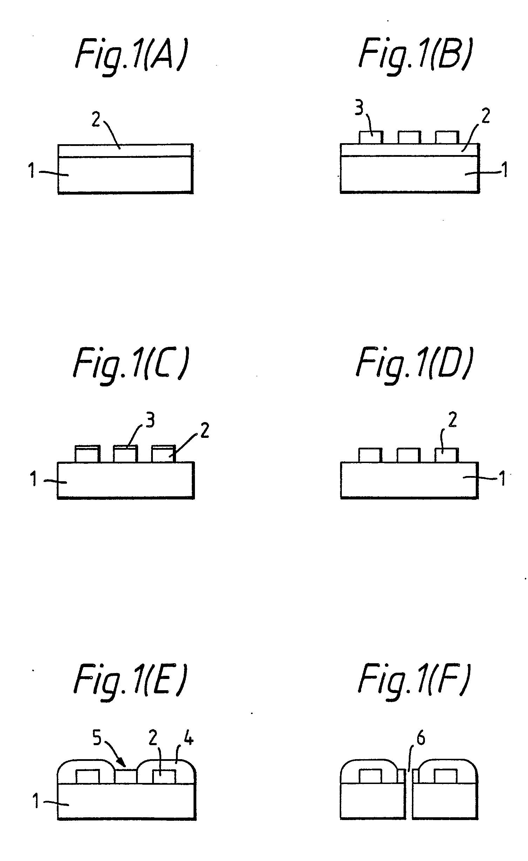

Such prior way of making printed circuit boards is illustrated in Figure 1 of the accompanying drawings. As shown in Figure 1A, the copper substrate is manufactured by attaching a thin copper film, in the form of a metal layer 2, having a thickness in the range of 1 to 40μm on a phenol resin or expoxy-glass resin base 1. Secondly, a circuit pattern is printed on the copper substrate, corrosion-resistant ink 3 is coated on the circuit pattern only so as to make it corrosion-resistant as shown in Figure 1B. Then, the substrate is immersed in a copper corrosive so as to etch the portion outside the circuit pattern, which is coated with a corrosion-resistant ink 3. Therefore the unetched portion forms the copper circuit as shown in Figure 1C.

After that, the corrosion-resistant ink 3 remaining on the circuit pattern is dissolved and removed in an alkali solution as shown in Figure 1D. As shown in Figure 1E, a heat-resistant electrically insulating ink 4 is applied to the copper circuit so as to assist insulation between the circuit parts. Moreover during soldering, lead will not stick except to the correct portions. Lastly, through holes 6 for components are formed at contact portions 5 of the substrate by punching with a press and the completed printed circuit board is then as shown in Figure 1F.

In the above-mentioned prior art, there are many problems from an economic and industrial standpoint. Namely, the production cost of printed circuit boards is very high because the thin copper film which is attached to the insulating base is very expensive and a large amount of copper is lost by the etching process. In addition, the process is very complicated because it requires etching of the copper film and dissolution of the corrosion-resistant ink. Besides the above-mentioned defects, air pollution and water contamination are induced by using the corrosive, and the equipment requirement for the copper etching process is very large.

The present invention is intended to overcome the above problems and to provide a low cost and simple process for making a durable printed circuit board.

In accordance with the present invention, a process for making a printed circuit board comprises the steps of (a) printing a circuit pattern using an electrically conductive material on at least one side of an electrically insulating substrate; (b) drying and hardening the circuit pattern; (c) directly forming a metal layer on only the circuit pattern by electroless and/or electro metal plating during a treatment time between 20 and 40 minutes; (d) printing an electrically insulating ink on ink on other than contact portions of the metal layer; and, (e) punching the resulting board with a press so as to form through holes where components are to be inserted at at least some of the contact portions.

Consequently, resulting from the invention, the public nuisance caused by the use of a corrosive and the loss of copper upon etching are not encountered, and the circuit is very firm. Mass production of the boards is also practical.

A multi-layer printed circuit board may be produced easily by including, between steps (d) and (e), the additional steps of (f) printing an electrically insulating ink on a connecting path between contact portions to be connected but not on the contact portions; (g) printing an electrically conductive material on the connecting path including the contact portions to be connected and (h) printing again an electrically insulating ink on other than at least some of the contact portions.

In the accompanying drawings:-

Fig. 1 are diagrammatic cross-sectional views showing a printed circuit board prepared according to the prior art;

Fig. 2 are diagrammatic cross-sectional views showing a single layer printed circuit board prepared according to the present invention; and,

Fig. 3 are diagrammatic cross-sectional views showing the development of the Fig. 2 process for preparing a multi-layer printed circuit board.

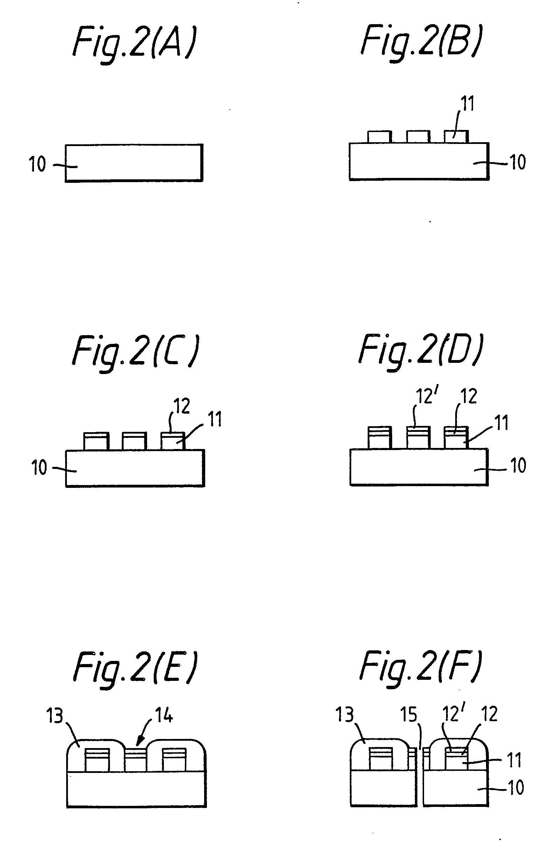

This invention is described in terms of making a printed circuit board in a low cost and simple process in which an electrically conductive material is silk-screen printed on an insulating substrate in the shape of a circuit pattern and a metal is deposited directly on the conductive resin later by an electroless and/or electro metal plating method without any previous treatment. As an example of the novel method used for the manufacture of a printed circuit board a base 10 is prepared as an insulating substrate, such as of a thermoset plastics resin, a thermo-plastics resin or a ceramic material cut to the proper size as shown in Fig. 2A. Phenol resin, expoxy resin, melamine resin or glyptal resin are examples of suitable thermoset plastics, and teflon resin, polyimide resin or engineering plastics are examples of suitable thermoplastics. A photograph of the desired circuit is made on film and the printed circuit plate is made by using a silk-screen net of 80 to 450 mesh, and conductive material 11 is silk-screened on to the substrate 10 in the circuit pattern, as shown in Fig. 2B, by using the plate (the first step). Then the printed pattern is completely dried and hardened at a temperature of 120°C to 300°C in 4 to 10 minutes and the circuit pattern is thus formed on, and securely bonded to, the substrate (the second step). The resulting circuit has an electrical pressure resistance of less than 10, and is thus distinguished from the insulating substrate.

A silver paste mixture which is mixed silver, varnish, thinner and vegetable oil, such as pine oil, may be used as the conductive material 11, but the composition of the conductive material 11 may be dependent on the material of the substrate 10. A suitable mixture comprises: silver 40 to 60 parts by weight; varnish 20 to 40 parts by weights; thinner 5 to 20 parts by weight; and vegetable oil 5 to 20 parts by weight. The silver mixed in the conductive resin 11 plays an important role as a catalyst in the electroless metal plating.

The varnish is preferably included in the conductive resin 11 in the range of between 20 and 40 parts because the metal plating does not take well on the circuit pattern when the varnish is included in an amount of below 20 parts or above 40 parts. The thinner is also preferably included in the above quoted range because that enhances the silk-screen printing of the conductive material. The third step in which a layer of metal plating 12 is formed on the circuit pattern on the substrate 10 by an electroless and/or electro metal plating method as shown in Fig. 2C. The substrate is first washed, to remove any impurities from the substrate surface, with a solvent such as acetone using a washing prior to performing the electroless metal plating in an electroless plating solution. It is best if the electroless plating time is between 20 and 40 minutes even if the presence of the deposition of metal ion in the electroless plating solution is largely dependant upon the temperature of solution, the adjustment range of the reductant (HCHO) and the amount of the metal in solution.

When the plating time is less than 20 minutes, the thickness of metal plating layer doesn't reach the required minimum value and when that time is greater than 40 minutes, the thickness of the metal plating layer is too great. Therefore it is desired that the electroless metal plating be performed in that range of time. Electro metal plating could be used as an alternative to the electroless plating.

If the metal plating 12 on the conductive material 11 is carried out by electroless plating, the thickness of the metal layer may be increased by a further electro metal plating step in which a further layer 12' is put down as shown in Fig. 2D. This may involve the use of a brush plating or carbon roller coating method in the conductive solution containing the metal ion.

The electroless or electro metal plating preferably performed using Cu, Ni, Au or Ag.

When an electroless or electro metal plating is process is performed on the conductive material layer 11 as described above, a metal plating layer 12, 12' with a thickness of 10 to 20μm may be formed in the pattern of the printed circuit. The metal layer may be pressed under a pressure of 150 to 200 kg/cm² in an hydraulic press for 3 to 15 minutes while heated to a temperature of 200-250°C so as to enhance its adhesive force. This is particularly useful when the board has a circuit printed on both faces. The the whole face of the substrate, except contact portions 14 are then screen printed with an electrically insulating ink 13, as shown in Fig. 2E. Holes 15 are then punched through the printed circuit board, as shown in Fig. 2F, to accommodate insertion of circuit components.

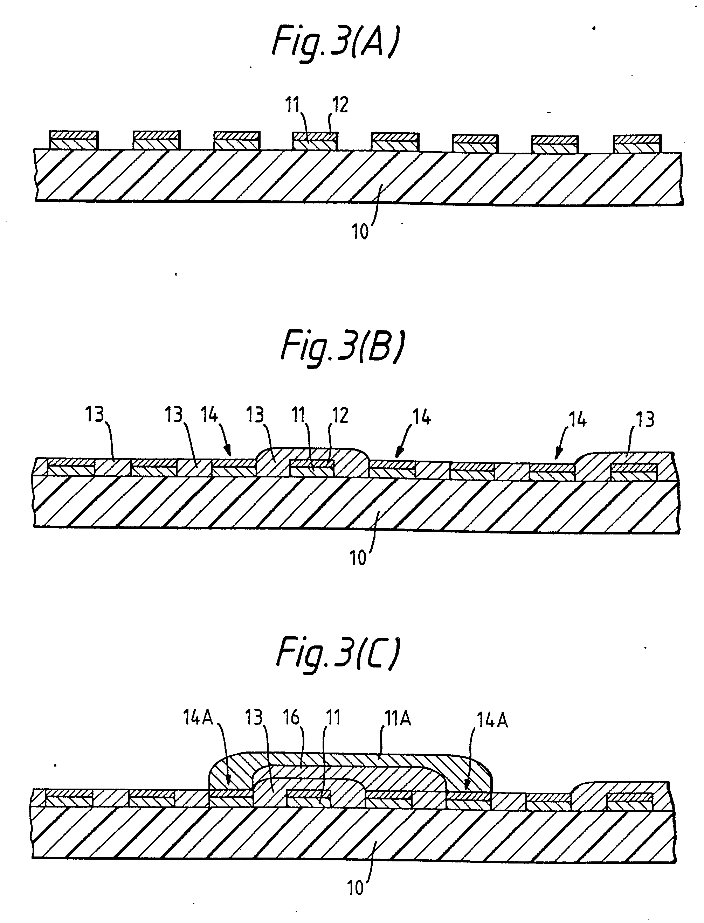

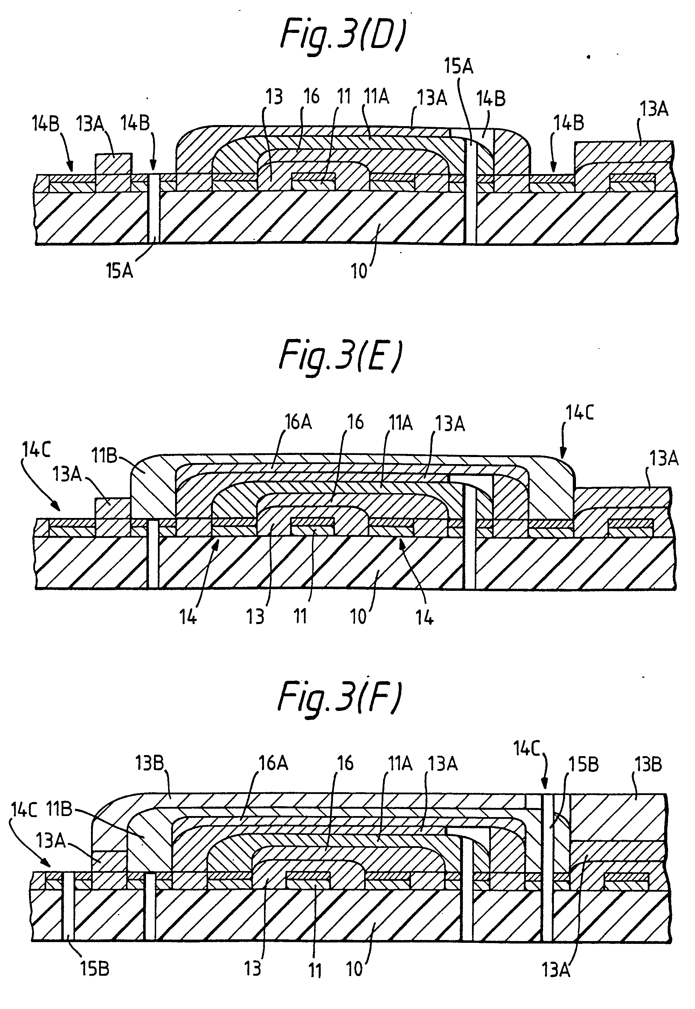

A multi-layer printed circuit board can be produced as shown in Figure 3. The initial steps are the same as before and Fig. 3A corresponds to Fig. 2C or 2D; and Fig. 3B corresponds to Fig. 2E. When two connecting portions, providing by contact portions 14A, are to be bridged by a connecting path, a second layer 16 of insulating ink is screen printed along the path, but short of the portions 14A, and more of the conductive material 11A is silk screen printed over the insulating ink and along the path and over the portions 14A, which are thus connected electrically as shown in Fig. 3C. An overall coating 13A of insulating ink is then applied again over all the substrate except for possibly for some of the contact portions 14A and portions 14B which need to be exposed for subsequent connections, as shown in Fig. 3D. Holes 15A may be formed through some of the exposed contact portions 14B to accommodate circuit components.

A third circuit layer can be added in the same manner as shown in Figs 3E and 3F, in which the additional parts 16A, 11B, 13B and 14C correspond to parts 16, 11A, 13A and 14B in Figures 3C and 3D, respectively. Again, as a final step, holes 15A are punched in one or more exposed contact portions 14C. Although the contact portions 14, 14A, 14B are shown convered in the later views of Figure 3, this is because the views are two dimensional sections. In practice circuit paths 11, 16, 16A would not be colinear so that at least some of the portions 14, 14A, 14B could also remain exposed through openings in the printed layers 13, 13A, 13B for connection to other components.

The following example describes the preparation of a printed circuit board in accordance with the invention in more detail.

The required circuit is photographed using film and a printing plate of 250 mesh silk-screen net is made. A phenol resin substrate is silk-screen printed, using the plate, with a conductive material which is a mixture of silver 50 parts by weight, varnish 30 parts by weight, thinner 10 parts by weight, and pine oil 10 parts by weight. The printed substrate is then dried at a temperature of 150°C for 5 minutes, and completely hardened at a temperature of 220°C for 8 minutes. Any impurities on the surface of the substrate are washed off with acetone using a washer, and the substrate is immersed into an electroless copper plating solution, to perform electroless copper plating for 30 minutes to form a copper plating layer 20 μm thick. The copper plating layer is coated with an IR insulating ink, and holes punched to obtain the final product of the printed circuit board.

It is possible to make a printed circuit board formed with a printed circuit on one or both faces, and to make a multi-layer printed circuit board by repeatedly performing the process in the same manner as above after coating additional bridging paths with an insulating ink to provide a double insulation between the paths and the underlying basic circuit. Plating on the conductive material defining the paths is not necessary.

In making the printed circuit boards in accordance with the prior art, the metal layer was bonded on the substrate using an adhesive, the circuit pattern was printed there and the corrosion process was performed to remove the metal layer from all portions except the printed circuit pattern. But in accordance with the present invention, the process for making the printed circuit boards is taken in steps, that is the conductive material is silk-screen printed on the substrate in the circuit pattern, and metal plating is performed directly without any previous treatment to form a metal layer on just the portion of the circuit pattern, the insulating ink is coated on, and the punching process performed to make the printed circuit boards.

Therefore, in preparing the printed circuit boards in accordance with the present invention, because a corrosion process is not needed, the serious problems of pollution are not encountered. When there is used for the conductive resin a silver paste including silver powder, the silver functions as a catalyst after an ageing process. Therefore the addition of a catalyst and an activating treatment step, which is a usual treatment step for the substrate in electroless plating is not needed. Also, in the prior art, the circuit was formed and then the contact positions were connected by carbon, as a result of which a number of inferior products was made due to the shorting phenomenon between the metal layer (about 40μm thick) and the carbon. Also forces caused the circuit board to twist, owing to contraction of the resin substrate after the circuit was formed. Nevertheless in the printed circuit board in accordance with the present invention, because the circuit board is formed after any contraction is complete, twisting of the substrate hardly occurs, particularly when the substrate is treated in a press. After the substrate has been provided with a copper circuit layer by electro metal plating by itself, or following electroless plating, all parts except the contact positions are coated with insulating ink, e.g. an epoxy resin. Therefore the shorting phenomenon is effectively eliminated.

When the printed circuit boards are made in accordance with the present invention, large apparatus that was required for the corrosion process of the metal layer in the prior art is not needed and an expensive substrate with the copper plate is not used, so that production costs are remarkably lowered. Also the pollution problem related to the use of a corrosion solution is completely solved by carrying out the electroless plating on the circuit directly and using the conductive material containing silver powder. A very large scale integrated electronic circuit boards can be made in a more simple manner.

In addition, it is possible to manufacture a multi-layer printed circuit board by the simple process of coating repeatedly with an insulating ink and conductive material on the single-layer circuit, prior to punching the holes for inserted components. Subsequently, the product is useful in any electronic goods requiring a small precise circuit.

## Claims

1. A process for making a printed circuit board, the process comprising the steps of (a) printing a circuit pattern using an electrically conductive material (11) on at least one side of an electrically insulating substrate (10); (b) drying and hardening the circuit pattern; (c) directly forming a metal layer (12,12′) on only the circuit pattern by electroless and/or electro metal plating during a treatment time of between 20 and 40 minutes; (d) printing an electrically insulating ink (13) on other than contact portions (14) of the metal layer; and, (e) punching the resulting board with a press so as to form through holes (15) where components are to be inserted at at least some of the contact portions.

2. A process according to claim 1, wherein the insulating substrate (10) consists of thermoset plastics resin, a thermoplastics resin or a ceramic material.

3. A process according to claim 2, wherein the thermoset plastics is selected from expoxy, melamine, or glyptal resin, and the thermoplastics from teflon, polyimide, or engineering plastics.

4. A process according to any one of the preceding claims, wherein the conductive material (11) is a mixture of a silver paste comprising 40 to 60 parts by weight of silver powder, 20 to 40 parts by weight of varnish, 5 to 20 parts by weight of thinner, and 5 to 20 parts by weight of a vegetable oil.

5. A process according to any one of the preceding claims, wherein the metal layer (12,12′) is made of copper, nickel, gold or silver.

6. A process according to any one of the preceding claims, wherein the thickness of the metal layer (12,12′) is in the range of 10 to 20μm.

7. A process according to any one of the preceding claims, wherein the drying and hardening step is carried out at a temperature in the range of 120°C to 300°C for between 4 and 10 minutes.

8. A process of manufacturing a multi-layer printed circuit board according to any one of the preceding claims, and including, between steps (d) and (e), the additional steps of (f) printing an electrically insulating ink on a connecting path (16) between contact portions to be connected but not on the contact portions (14A); (g) printing an electrically conductive material (11A) on the connecting path including the contact portions to be connected and (h) printing again an electrically insulating ink (13A) on other than at least some of the contact portions.

9. A process according to claim 8, wherein steps (f) to (h) are repeated one or more times.

10. A process according to any one of the preceding claims, wherein the electrically conductive material is silk screen printed and the electrically insulating ink is screen printed.

EP 0 322 997 A2

Fig.1(A)

Fig.1(B)

Fig.1(C)

Fig.1(D)

Fig.1(E)

Fig.1(F)

Fig.2(A)

Fig.2(B)

Fig.2(C)

Fig.2(D)

Fig.2(E)

Fig.2(F)

## Fig.3(A)

## Fig.3(B)

## Fig.3(C)

*Fig.3(D)*

*Fig.3(E)*

*Fig.3(F)*